(19) Europäisches Patentamt / European Patent Office / Office européen des brevets

(11) **EP 4 343 349 B1**

(12) **EUROPEAN PATENT SPECIFICATION**

(45) Date of publication and mention
of the grant of the patent:
**27.08.2025  Bulletin 2025/35**

(21) Application number: **22899017.2**

(22) Date of filing: **23.11.2022**

(51) International Patent Classification (IPC):
*G01R 31/387* (2019.01)   *G01R 31/392* (2019.01)
*G01R 31/382* (2019.01)   *H02J 7/00* (2006.01)
*H01M 10/48* (2006.01)   *H01M 10/44* (2006.01)

(52) Cooperative Patent Classification (CPC):
**G01R 31/392; G01R 31/387; H01M 10/44;**
**H01M 10/48; H02J 7/005;** G01R 31/3828;
Y02E 60/10

(86) International application number:
**PCT/KR2022/018592**

(87) International publication number:
**WO 2023/096335 (01.06.2023 Gazette 2023/22)**

(54) **BATTERY ABNORMALITY DIAGNOSING APPARATUS AND METHOD**

VORRICHTUNG UND VERFAHREN ZUR DIAGNOSE VON BATTERIEANOMALIEN

APPAREIL ET PROCÉDÉ DE DIAGNOSTIC D'UNE ANOMALIE DE BATTERIE

(84) Designated Contracting States:
**AL AT BE BG CH CY CZ DE DK EE ES FI FR GB**
**GR HR HU IE IS IT LI LT LU LV MC ME MK MT NL**
**NO PL PT RO RS SE SI SK SM TR**

(30) Priority: **26.11.2021  KR 20210166209**
**22.11.2022  KR 20220157731**

(43) Date of publication of application:
**27.03.2024  Bulletin 2024/13**

(73) Proprietor: **LG Energy Solution, Ltd.**
**Seoul 07335 (KR)**

(72) Inventors:
• **LEE, Sun-Jong**
**Daejeon 34122 (KR)**
• **KIM, Cheol-Taek**
**Daejeon 34122 (KR)**

(74) Representative: **Plasseraud IP**
**104 Rue de Richelieu**
**CS92104**
**75080 Paris Cedex 02 (FR)**

(56) References cited:
JP-A- 2013 196 820    JP-A- 2020 140 884
JP-A- 2020 169 968    JP-B2- 5 041 065
JP-B2- 6 535 890    US-A1- 2012 179 398
US-A1- 2013 076 363    US-A1- 2017 279 171
US-A1- 2019 140 325

## Description

### TECHNICAL FIELD

The present disclosure relates to a battery abnormality diagnosing apparatus and method, and more particularly, to a battery abnormality diagnosing apparatus and method capable of accurately diagnosing whether a battery is abnormal regardless of an error of a current sensor by time-sequentially analyzing the difference between a charge capacity and a discharge capacity.

The present application claims priority to Korean Patent Application No. 10-2021-0166209 filed on November 26, 2021, and Korean Patent Application No. 10-2022-0157731 filed on November 22, 2022 in the Republic of Korea.

### BACKGROUND ART

Batteries used in electric vehicles or energy storage systems (ESS) may ignite in use. One of the most likely causes of ignition is lithium precipitation on the surface of the negative electrode.

In the case of a normal battery, lithium ions emitting from the positive electrode must diffuse into the negative electrode during charging. However, in the case of a defective battery, some lithium ions are precipitated in the form of lithium metal on the surface of the negative electrode. Precipitated lithium continues to grow in the form of dendrite in the repetitive charging process.

Lithium precipitated on the surface of the negative electrode comes into contact with an adjacent positive electrode current collecting plate or an adjacent negative electrode current collecting plate, causing an internal short circuit. The internal short circuit rapidly raises the temperature inside the battery and, in serious cases, even causes a fire accident.

Therefore, battery manufacturers are actively conducting research and development on technology for diagnosing lithium precipitation.

One of the prior art for diagnosing lithium precipitation is based on analyzing the change pattern of voltage when the battery enters a rest mode after being charged. When the battery enters the rest mode after being charged, the polarization of the electrode surface is relieved and the voltage is gradually lowered to reach an equilibrium state. However, if lithium precipitation occurs in the charge cycle, when the battery enters the rest mode, the lithium precipitated on the surface of the negative electrode diffuses into the negative electrode, and fine charging continues. Therefore, the voltage profile of the battery where lithium precipitation occurs includes an inflection point, and lithium precipitation can be diagnosed by detecting the appearance of the inflection point. However, in this diagnostic technology, the inflection point can be detected only when a large amount of lithium precipitation occurs in the charge cycle. That is, when the amount of lithium precipitation is not large, it is not easy to diagnose lithium precipitation.

Meanwhile, when the battery is discharged, lithium comes out from the negative electrode and is inserted into the positive electrode again. However, the lithium precipitated on the surface of the negative electrode cannot participate in such a reaction, so the discharge capacity of the battery with lithium precipitation is smaller than the charge capacity. Therefore, by analyzing the difference between charge capacity and the discharge capacity, it is possible to diagnose lithium precipitation. However, it is difficult to trust the diagnosis result if the charge capacity and the discharge capacity show an error from the actual true value due to an error of the current sensor. For reference, when a sense resistor is used as a current sensor, an error occurs in the process of amplifying the voltage applied to both ends of the sense resistor and converting the amplified voltage from analog signal to digital data. Even if the magnitudes of the charging current and discharging current are the same, the actual measured value may show a difference depending on the offset of the current sensor. Therefore, there is also a limit to diagnosing lithium precipitation only with the difference between the charge capacity and the discharge capacity. US 2019/140325 A1 discloses a battery management system comprising a detection circuit with a current sensor and a control circuit . The control circuit can determine the increase rate of the charging current, according to a difference of the charging currents at different times, when the metal battery is in a constant voltage charging state. When a difference between two adjacent total discharging capacities and/or a difference between two adjacent total discharging energies are greater than the corresponding preset values, the control circuit can determine that the dendrites are formed inside the one or more battery cells of the metal battery.

### DISCLOSURE

#### Technical Problem

The present disclosure is designed to solve the problems of the related art, and therefore the present disclosure is directed to providing a battery abnormality diagnosing apparatus and method having robustness to an error of a current sensor in diagnosing lithium precipitation based on the difference between a charge capacity and a discharge capacity.

In addition, the present disclosure is directed to providing a system or an electric vehicle including the battery abnormality diagnosing apparatus.

#### Technical Solution

In one aspect of the present disclosure, there is provided a battery abnormality diagnosing apparatus, comprising: a current measuring unit configured to measure a charging current or a discharging current of a battery; and a control unit operably coupled with the current measuring unit and configured to diagnose a lithium precipitation abnormality while performing a plurality of charge/discharge cycles for the battery.

The control unit is configured to receive a current measurement value from the current measuring unit in a $k^{th}$ (k is a natural number greater than or equal to 2) charge/discharge cycle to calculate a charge capacity (ChgAh[k]) and a discharge capacity (DchgAh[k]), determine a capacity difference (dAh[k]) corresponding to a difference between the charge capacity (ChgAh[k]) and the discharge capacity (DchgAh[k]), determine a $k^{th}$ capacity difference change amount ($\triangle$dAh[k]) by subtracting the capacity difference (dAh[k]) of the $k^{th}$ charge/discharge cycle from a capacity difference (dAh[k-1]) of a k-1$^{th}$ charge/discharge cycle, update an accumulated capacity difference change amount by adding the $k^{th}$ capacity difference change amount ($\triangle$dAh[k]) to the accumulated capacity difference change amount, and diagnose that a lithium precipitation abnormality occurs when the updated accumulated capacity difference change amount is greater than or equal to a threshold value.

Preferably, the control unit may be configured to update the accumulated capacity difference change amount by adding the $k^{th}$ capacity difference change amount ($\triangle$dAh[k]) to the accumulated capacity difference change amount when the $k^{th}$ capacity difference change amount ($\triangle$dAh[k]) is greater than a reference value.

Preferably, the control unit may be configured to update the accumulated capacity difference change amount by adding the $k^{th}$ capacity difference change amount ($\triangle$dAh[k]) to the accumulated capacity difference change amount when both the k-1$^{th}$ capacity difference change amount ($\triangle$dAh[k-1]) and the $k^{th}$ capacity difference change amount ($\triangle$dAh[k]) are greater than a reference value.

Preferably, the control unit may be configured to assign an initial value of 0 to the accumulated capacity difference change amount when the $k^{th}$ capacity difference change amount ($\triangle$dAh[k]) is less than or equal to a reference value.

Preferably, the reference value may be 0.

In an embodiment, when performing each charge/discharge cycle, the control unit may be configured to perform the charge cycles in the same charging voltage section and perform the discharge cycles in the same discharging voltage section.

In another embodiment, when performing each charge/discharge cycle, the control unit may be configured to perform the charge cycles in the same charging voltage section and perform the discharge cycles in the same discharge capacity condition.

Preferably, the battery abnormality diagnosing apparatus according to the present disclosure may further comprise a display coupled to the control unit, and the control unit may be configured to diagnose that a lithium precipitation abnormality occurs when the accumulated capacity difference change amount is greater than or equal to the threshold value and output a diagnosis result through the display.

In another aspect of the present disclosure, there is provided a battery abnormality diagnosing method, comprising: (a) receiving a current measurement value from a current measuring unit in a $k^{th}$ (k is a natural number greater than or equal to 2) charge/discharge cycle to calculate a charge capacity and a discharge capacity; (b) determining a capacity difference corresponding to a difference between the charge capacity and the discharge capacity; (c) determining a $k^{th}$ capacity difference change amount by subtracting the capacity difference of the $k^{th}$ charge/discharge cycle from a capacity difference of a k-1$^{th}$ charge/discharge cycle; (d) updating an accumulated capacity difference change amount by adding the $k^{th}$ capacity difference change amount to the accumulated capacity difference change amount; and (e) diagnosing that a lithium precipitation abnormality occurs when the updated accumulated capacity difference change amount is greater than or equal to a threshold value.

In another aspect of the present disclosure, there is provided a system and an electric vehicle, comprising the battery abnormality diagnosing apparatus.

Advantageous Effects

According to an embodiment of the present disclosure, it is possible to reliably diagnose whether the battery is abnormal by quantifying the possibility of lithium precipitation inside the battery using a factor that is called an accumulated capacity difference change amount, which is not affected by a current measurement error.

According to another embodiment of the present disclosure, even if measurement values for a charging current and a discharging current have errors from actual values, it is possible to reliably diagnose whether the battery is abnormal.

According to still another embodiment of the present disclosure, even if the measurement error of the charging current and the measurement error of the discharging current are different, it is possible to reliably diagnose whether the battery is abnormal.

According to still another embodiment of the present disclosure, the accumulated capacity difference change amount is calculated by integrating the capacity difference change amount only when the condition in which the capacity difference change amount calculated in each charge/discharge cycle exceeds a reference value is continuously satisfied, and when an event in which the capacity difference change amount does not exceed the reference value occurs, the accumulated capacity difference change amount is reset to 0, thereby minimizing the noise effect.

According to still another embodiment of the present disclosure, various systems and electric vehicles including the battery abnormality diagnosing apparatus may be provided.

DESCRIPTION OF DRAWINGS

The accompanying drawings illustrate a preferred embodiment of the present disclosure and together with the foregoing disclosure, serve to provide further understanding of the technical features of the present disclosure, and thus, the present disclosure is not construed as being limited to the drawing.

FIG. 1 is a block diagram showing a schematic configuration of a battery abnormality diagnosing apparatus 10 according to an embodiment of the present disclosure.

FIGS. 2 to 5 are flowcharts for specifically illustrating a process of diagnosing a lithium precipitation abnormality while a control unit repeatedly performs a charge/discharge cycle according to an embodiment of the present disclosure.

FIG. 6 is a graph showing the change in data measured in an experimental example to which a battery abnormality diagnosing method according to an embodiment of the present disclosure is applied.

FIG. 7 is a graph showing the change in data measured in another experimental example to which the battery abnormality diagnosing method according to an embodiment of the present disclosure is applied.

BEST MODE

Hereinafter, preferred embodiments of the present disclosure will be described in detail with reference to the accompanying drawings. Prior to the description, it should be understood that the terms used in the specification and the appended claims should not be construed as limited to general and dictionary meanings, but interpreted based on the meanings and concepts corresponding to technical aspects of the present disclosure on the basis of the principle that the inventor is allowed to define terms appropriately for the best explanation. Therefore, the description proposed herein is just a preferable example for the purpose of illustrations only, not intended to limit the scope of the disclosure, so it should be understood that other equivalents and modifications could be made thereto without departing from the scope of the disclosure.

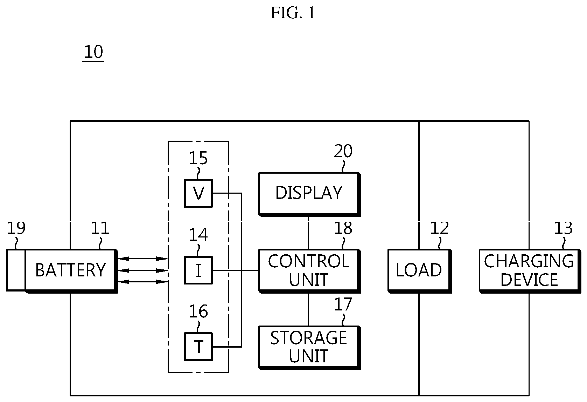

FIG. 1 is a block diagram showing a schematic configuration of a battery abnormality diagnosing apparatus 10 according to an embodiment of the present disclosure.

Referring to FIG. 1, the battery abnormality diagnosing apparatus 10 may diagnose lithium precipitation of a battery 11 while performing the charge/discharge cycle of the battery 11 multiple times.

The battery abnormality diagnosing apparatus 10 may be a dedicated device for diagnosing the battery 11. When the battery 11 is mounted in an electric vehicle, the battery abnormality diagnosing apparatus 10 may be included in a diagnosing system provided in a maintenance shop of the electric vehicle. A user of an electric vehicle may visit a maintenance shop regularly and receive a battery abnormality diagnosis service. At this time, the battery abnormality diagnosing apparatus 10 of the diagnosing system may be connected to the battery 11 of the electric vehicle to diagnose the abnormality of the battery 11. Preferably, the abnormality diagnosis is lithium precipitation on the surface of a negative electrode of the battery 11.

Alternatively, the battery abnormality diagnosing apparatus 10 may be included in control elements of various systems in which the battery 11 is installed. In one example, when the battery 11 is included in an energy storage system, the abnormality diagnosing apparatus 10 may be included in a control element (e.g., an ESS control system) of the energy storage system. In another example, when the battery 11 is included in an electric vehicle, the abnormality diagnosing apparatus 10 may be included in a control element (e.g., a vehicle control system) of the electric vehicle.

In an embodiment of the present disclosure, the charge/discharge cycle includes a charge cycle and a discharge cycle.

In one example, the charge cycle means to charge the battery from a lower limit to an upper limit of a preset charging voltage section while maintaining the temperature of the battery 11 constant and then stop charging. The discharge cycle means that after the charge cycle is completed, the battery 11 is stabilized for a predetermined time, the battery is discharged from an upper limit to a lower limit of a preset discharging voltage section while maintaining the temperature of the battery 11 in the same way as the charge cycle, and then the discharge is stopped. The charging voltage section and the discharging voltage section may be the same or different. However, in performing a plurality of charge/discharge cycles, it is preferable that charging voltage sections between charge cycles are the same and discharging voltage sections between discharge cycles are also the same.

In another example, the charge cycle means to charge the battery from the lower limit to the upper limit of the preset charging voltage section while maintaining the temperature of the battery 11 constant and then stop charging. The discharge cycle means that the discharge starts from the upper limit of the preset discharging voltage section, and by integrating the discharging current, the discharging is stopped when the current integration value reaches a preset discharge capacity. In performing a plurality of charge/discharge cycles, it is preferable that charging voltage sections between charge cycles are the same and discharge capacities between discharge cycles are the same.

The battery 11 may be a lithium secondary battery, but the present disclosure is not limited by the type of battery. Therefore, any secondary battery that can be repeatedly charged and discharged may correspond to the battery 11. The battery 11 includes at least one unit cell. The unit cell may be a pouch cell, a cylindrical cell or a prismatic cell. When there are a plurality of unit cells, the unit cells may be connected in series and/or in parallel.

In an embodiment of the present disclosure, it is assumed that the battery 11 includes one unit cell or a plurality of unit cells connected in parallel. However, the present disclosure is not limited by the number of unit cells and the electrical connection relationship between unit cells.

When the battery 11 includes a plurality of unit cells connected in series, it is obvious to those skilled in the art that the embodiment of the present disclosure can be applied to diagnose abnormality of each unit cell.

The battery 11 may be connected to a load 12 for performing the discharge cycle. The load 12 may include a discharge element such as a resistor. Alternatively, the load 12 consumes energy of the battery 11 and may be a motor of an electric vehicle, an electric device connected to a power system, or a power conversion device such as an inverter or a converter.

The battery 11 may be connected to a charging device 13 for performing the charge cycle. The charging device 13 may be a dedicated charging device for diagnosing abnormality of the battery 11. Alternatively, the charging device 13 may be a charging station of an electric vehicle or a power converting system (PCS) of an energy storage system. The present disclosure is not limited by the type of the load 12 or the charging device 13.

The battery abnormality diagnosing apparatus 10 may include a current measuring unit 14 that measures current flowing through the battery 11. The current may be a charging current or a discharging current. The current measuring unit 14 measures the current flowing through the battery 11 at regular time intervals and outputs the current measurement value to the control unit 16. Preferably, the current measuring unit 14 may be installed on a line through which the charging current and the discharging current flow.

The current measuring unit 14 may be a current measuring circuit. The current measuring unit 14 may include a hall sensor or a sense resistor that outputs a voltage value corresponding to the magnitude of current. The voltage value output from the hall sensor or the voltage value at both ends of the sense resistor may be converted into a current value according to Ohm's law. Conversion of a voltage value to a current value may be handled by a control unit 18. To this end, the control unit 18 may include an I/O interface coupled with the current measuring unit 14, an amplifier circuit that amplifies the voltage signal input through the I/O interface, and an analog-digital conversion circuit that digitizes the voltage signal output from the amplifier circuit.

The current measurement value measured using the current measuring unit 14 may have an error with the actual value. In one example, when the current measuring unit 14 is a sense resistor, the amplifier circuit that detects voltage at both ends of the sense resistor may have different gains depending on the direction of current flowing through the sense resistor. Therefore, when the current measuring unit 14 is a sense resistor, the measurement values may be different even if the magnitudes of the charging current and discharging current are the same.

The battery abnormality diagnosing apparatus 10 may include a voltage measuring unit 15 that measures the voltage of the battery 11. The voltage measuring unit 15 measures the voltage of the battery 11 at regular time intervals while the battery 11 is being charged or discharged, and outputs the voltage measurement value to the control unit 18. The voltage measuring unit 15 may be a voltage measuring circuit known in the art. Since the voltage measurement circuit is widely known, it will not be described in detail.

The battery abnormality diagnosing apparatus 10 may include a temperature measuring unit 16. The temperature measuring unit 16 measures the temperature of the battery 11 at regular time intervals while the battery 11 is being charged or discharged, and outputs the temperature measurement value to the control unit 18. The temperature measuring unit 16 may be a temperature measuring circuit. The temperature measuring unit 16 may include a thermocouple or a temperature measuring element that outputs a voltage value corresponding to temperature. The voltage value may be converted into a temperature value by using a voltage-temperature conversion look-up table (function). Conversion of voltage value to temperature value may be handled by the control unit 18.

The battery abnormality diagnosing apparatus 10 may include a storage unit 17. The type of storage unit 17 is not particularly limited as long as it can record and erase data and/or information. As an example, the storage unit 17 may be a RAM, a ROM, a register, a flash memory, a hard disk, or a magnetic recording medium.

The storage unit 17 may be electrically connected to the control unit 18 via, for example, a data bus to allow access by the control unit 18.

The storage unit 17 stores and/or updates and/or erase and/or transmit programs including various control logics executed by the control unit 18, and/or data generated when control logics are executed, and/or preset data, parameters, lookup information/tables, etc.

Preferably, the control unit 18 is operably coupled to the current measuring unit 14, the voltage measuring unit 15, the temperature measuring unit 16 and the storage unit 17.

The control unit 18 may perform charge/discharge cycles multiple times while constantly maintaining the temperature of the battery 18 at a set temperature in order to diagnose abnormality of the battery 11. The control unit 18 may connect the charging device 13 with the battery 11 when performing the charge cycle, and may connect the load 12 with the battery 11 when performing the discharge cycle.

The control unit 18 may be operably coupled with the temperature adjusting unit 19 to keep the temperature of the battery 11 constant. The temperature adjusting unit 19 may include an electric heater or a fluid circulation loop. The control unit 18 may maintain the temperature of the battery 11 at the set temperature by controlling the temperature adjusting unit 19. In one example, the control unit 18 may maintain the temperature of the battery 11 constant at the set temperature by adjusting the power of the electric heater or adjusting the temperature of the fluid supplied to the fluid circulation loop. The temperature adjusting unit 19 may be coupled with the battery 11 to come into contact with the surface of the battery 11.

During the charge/discharge cycle, the control unit 18 may periodically measure the amount of current flowing through the battery 11 using the current measuring unit 14 and record the current measurement value in the storage unit 17 along with a time stamp.

The control unit 18 may also periodically measure the voltage of the battery 11 through the voltage measuring unit 15 during the charge/discharge cycle and record the voltage measurement value in the storage unit 17 together with a time stamp.

The control unit 18 may also periodically measure the temperature of the battery 11 through the temperature measuring unit 16 during the charge/discharge cycle and record the temperature measurement value in the storage unit 17 together with a time stamp.

Preferably, the control unit 18 may diagnose a lithium precipitation abnormality while performing a plurality of charge/discharge cycles for the battery 11. The number of charge/discharge cycles to diagnose a lithium precipitation abnormality may be preset. In one example, the number of charge/discharge cycles may be 20.

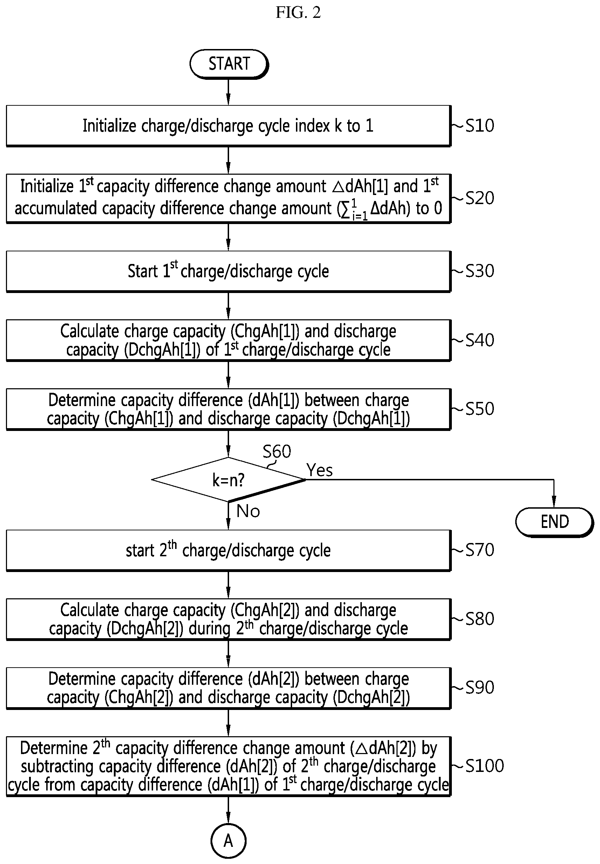

FIGS. 2 to 5 are flowcharts for specifically illustrating a process of diagnosing a lithium precipitation abnormality while a control unit repeatedly performs a charge/discharge cycle according to an embodiment of the present disclosure.

The control unit 18 may execute a battery abnormality diagnosing method according to an embodiment of the present disclosure according to the flowcharts shown in FIGS. 2 to 5.

First, the control unit 18 initializes the charge/discharge cycle index k to 1 in Step S10, and initializes a 1st capacity difference change amount $\triangle dAh[1]$ and a 1st accumulated capacity difference change amount (

$$\sum_{i=1}^{1} \triangle dAh$$

) to 0 in Step S20, respectively.

Subsequently, the control unit 18 starts the 1st charge/discharge cycle for the battery 11 in Step S30.

Subsequently, in Step S40, the control unit 18 receives the current measurement value from the current measuring unit 14 during the 1st charge/discharge cycle and calculates a charge capacity (ChgAh[1]) and discharge capacity (DchgAh[1]).

In step S40, the control unit 18 may control the charging device 13 to perform a charge cycle in a preset charging voltage section. In addition, the control unit 18 may perform a discharge cycle in a preset discharging voltage section by connecting the battery 11 to the load 12 after performing the charge cycle. The charging voltage section and the discharging voltage section may be the same or different. Preferably, the discharge cycle starts after the voltage of the battery 11 is stabilized after the charge cycle is completed. In addition, the discharge cycle may end when the voltage of the battery 11 reaches a preset discharge end voltage or when the integrated value of the discharging current reaches a preset discharge capacity. When the start and end of the charge cycle and the discharge cycle are controlled based on the voltage value, the control unit 18 may refer to the voltage measurement value of the battery 11 measured through the voltage measuring unit 15. During the charge cycle and the discharge cycle, the control unit 18 may control the temperature adjusting unit 19 to keep the temperature of the battery 11 constant. Here, temperature may be selected as an arbitrary value within the operating temperature range of the battery 11.

In step S50, the control unit 18 may determine a capacity difference (dAh[1]) corresponding to the difference between the charge capacity (ChgAh[1]) and the discharge capacity (DchgAh[1]) and record the capacity difference in the storage unit 17 together with a time stamp. In one example, the capacity difference (dAh[1]) may be determined by subtracting the discharge capacity (DchgAh[1]) from the charge capacity (ChgAh[1]).

Then, at Step S60, the control unit 18 judges whether the index k for the charge/discharge cycle is equal to n. n is a natural number preset as the total number of charge/discharge cycles that can be performed to diagnose a lithium precipitation abnormality. In one example, n may be 20. In another example, n may be a value greater than or smaller than 20.

If the judgment in Step S60 is YES, the control unit 18 terminates the abnormality diagnosis process of the battery 11. Meanwhile, if the judgment at Step S60 is NO, the control unit 18 transfers the process to S70.

In Step S70, the control unit 18 starts the 2th charge/discharge cycle. Conditions of the 2th charge/discharge cycle are substantially the same as those of the 1st charge/discharge cycle.

Subsequently, the control unit 18 determines a charge capacity (ChgAh[2]) and a discharge capacity (DchgAh[2]) during the 2th charge/discharge cycle for the battery 11 in Step S80, and determines a capacity difference (dAh[2]) corresponding to the difference between the charge capacity (ChgAh[2]) and the discharge capacity (DchgAh[2]) in Step S90.

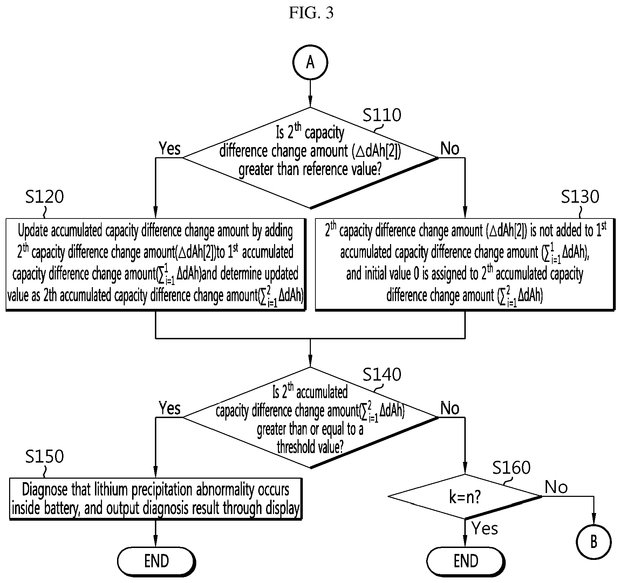

Then, the control unit 18 determines a 2ᵗʰ capacity difference change amount ($\triangle$dAh[2]) by subtracting the capacity difference (dAh[2]) of the 2ᵗʰ charge/discharge cycle from the capacity difference (dAh[1]) of the 1ˢᵗ charge/discharge cycle in Step S100. After Step S100, Step S110 of FIG. 3 is performed.

Subsequently, the control unit 18 judges whether the 2ᵗʰ capacity difference change amount ($\triangle$dAh[2]) is greater than a reference value in Step S110. Preferably, the reference value may be 0, but the present disclosure is not limited thereto.

If the judgment in Step S110 is YES, in Step S120, the control unit 18 updates an accumulated capacity difference change amount by adding the 2ᵗʰ capacity difference change amount ($\triangle$dAh[2]) to the 1ˢᵗ accumulated capacity difference change amount (

$$\sum_{i=1}^{1} \triangle dAh$$

) and determines the updated value as

a 2ᵗʰ accumulated capacity difference change amount (

$$\sum_{i=1}^{2} \triangle dAh$$

). For reference, the 1ˢᵗ accumulated

capacity difference change amount ( $\sum_{i=1}^{1} \triangle dAh$ )

is the initialization value of 0.

Meanwhile, if the judgment in Step S110 is NO, the 2ᵗʰ capacity difference change amount ($\triangle$dAh[2]) is not added to the 1ˢᵗ accumulated capacity difference

change amount ( $\sum_{i=1}^{1} \triangle dAh$ ), and the initial value 0 is assigned to the 2ᵗʰ accumulated capacity difference

change amount ( $\sum_{i=1}^{2} \triangle dAh$ ).

Subsequently, the control unit 18 judges whether the 2ᵗʰ accumulated capacity difference change amount ( $\sum_{i=1}^{2} \triangle dAh$ ) is greater than or equal to a threshold value in Step S140. The threshold value may be set to a value suitable for diagnosing a lithium precipitation abnormality. In one example, the threshold value may be set to 0.1% of the capacity of the battery 11, but the present disclosure is not limited thereto.

If the judgment in Step S140 is YES, the control unit 18 may diagnose that a lithium precipitation abnormality occurs inside the battery 11, and output the diagnosis result through the display 20. Preferably, the diagnosis result includes a warning message indicating that a lithium precipitation abnormality occurs. The control unit 18 may end the diagnosis process after outputting the diagnosis result including a warning message through the display 20 in Step S150.

If the judgment in Step S140 is NO, that is, if the 2ᵗʰ accumulated capacity difference change amount (

$$\sum_{i=1}^{2} \triangle dAh$$

) is less than the threshold value (or, is 0), the control unit 18 judges whether the index k for the charge/discharge cycle is identical to n in Step S160. Here, n is the total number of charge/discharge cycles that can be performed to diagnose a lithium precipitation abnormality.

If the judgment in Step S160 is YES, since the charge/discharge cycles for diagnosing lithium precipitation are completely performed, it is finally diagnosed that no lithium precipitation abnormality occurs inside the battery 11, and the process is terminated. The control unit 18 may output the final diagnosis result through the display 20. The final diagnosis result may include a message indicating that no lithium precipitation abnormality occurs.

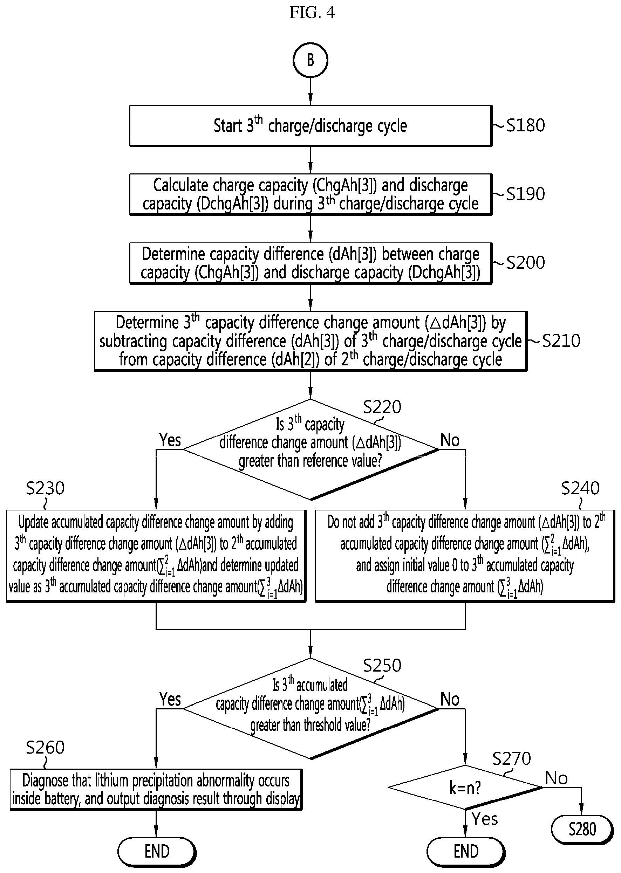

Meanwhile, if the judgment in Step S160 is NO, the control unit 18 may further perform a charge/discharge cycle to diagnose a lithium precipitation abnormality. After Step S160, Step S180 of FIG. 4 is performed.

That is, in Step S180, the control unit 18 starts the 3ᵗʰ charge/discharge cycle. Conditions of the 3ᵗʰ charge/discharge cycle are substantially the same as those of the 1ˢᵗ charge/discharge cycle.

Subsequently, the control unit 18 determines a charge capacity (ChgAh[3]) and a discharge capacity (DchgAh[3]) during the 3ᵗʰ charge/discharge cycle for the battery 11 in Step S190, and determines a capacity difference (dAh[3]) corresponding to the difference between the charge capacity (ChgAh[3]) and the discharge capacity (DchgAh[3]) in Step S200.

Subsequently, the control unit 18 determines a 3ᵗʰ capacity difference change amount ($\triangle$dAh[3]) by subtracting the capacity difference (dAh[3]) of the 3ᵗʰ charge/discharge cycle from the capacity difference (dAh[2]) of the 2ᵗʰ charge/discharge cycle in Step S210.

Subsequently, the control unit 18 judges whether the 3ᵗʰ capacity difference change amount ($\triangle$dAh[3]) is greater than the reference value in Step S220. Preferably, the reference value may be 0, but the present disclosure is not limited thereto.

If the judgment in Step S220 is YES, in Step S230, the control unit 18 updates an accumulated capacity difference change amount by adding the 3ᵗʰ capacity difference change amount ($\triangle$dAh[3]) to the 2ᵗʰ accumulated capacity difference change amount (

$$\sum_{i=1}^{2} \triangle dAh$$

) and determines the updated value as

a 3ᵗʰ accumulated capacity difference change amount (

$$\sum_{i=1}^{3} \triangle dAh \Big).$$

Meanwhile, if the judgment in Step S220 is NO, in Step S240, the control unit 18 does not add the 3th capacity difference change amount ($\triangle$dAh[3]) to the 2th accumulated capacity difference change amount (

$$\sum_{i=1}^{2} \triangle dAh$$

), and assign the initial value 0 to the 3th accumulated capacity difference change amount (

$$\sum_{i=1}^{3} \triangle dAh$$

).

After Step S230 and Step S240, Step S250 is performed.

In Step S250, the control unit 18 judges whether the 3th accumulated capacity difference change amount (

$$\sum_{i=1}^{3} \triangle dAh$$

) is equal to or greater than the threshold value.

If the judgment in Step S250 is YES, in Step S260, the control unit 18 may diagnose that a lithium precipitation abnormality occurs inside the battery 11, and output the diagnosis result through the display 20. Preferably, the diagnosis result includes a warning message indicating that a lithium precipitation abnormality occurs. The control unit 18 may end the diagnosis process after outputting the diagnosis result including a warning message through the display 20 in Step S260.

If the judgment in Step S250 is NO, that is, if the 3th accumulated capacity difference change amount (

$$\sum_{i=1}^{3} \triangle dAh$$

) is less than the threshold value (or, is 0), the control unit 18 judges whether the index k for the charge/discharge cycle is identical to n in Step S270. Here, n is the total number of charge/discharge cycles that can be performed to diagnose whether lithium precipitation occurs inside the battery 11.

If the judgment in Step S270 is YES, since the charge/discharge cycles for diagnosing a lithium precipitation abnormality are completely performed, it is finally diagnosed that no lithium precipitation abnormality occurs inside the battery 11, and the process is terminated. The control unit 18 may output a final diagnosis result through the display 20. The final diagnosis result may include a message indicating that no lithium nrecinitation abnormality occurs.

Meanwhile, if the judgment in Step S270 is NO, the control unit 18 may further perform a charge/-discharge cycle to diagnose a lithium precipitation abnormality.

A diagnosis logic for diagnosing a lithium precipitation abnormality performed by the control unit 18 in a 4th charge/discharge cycle and subsequent charge/-discharge cycles is substantially the same as described above.

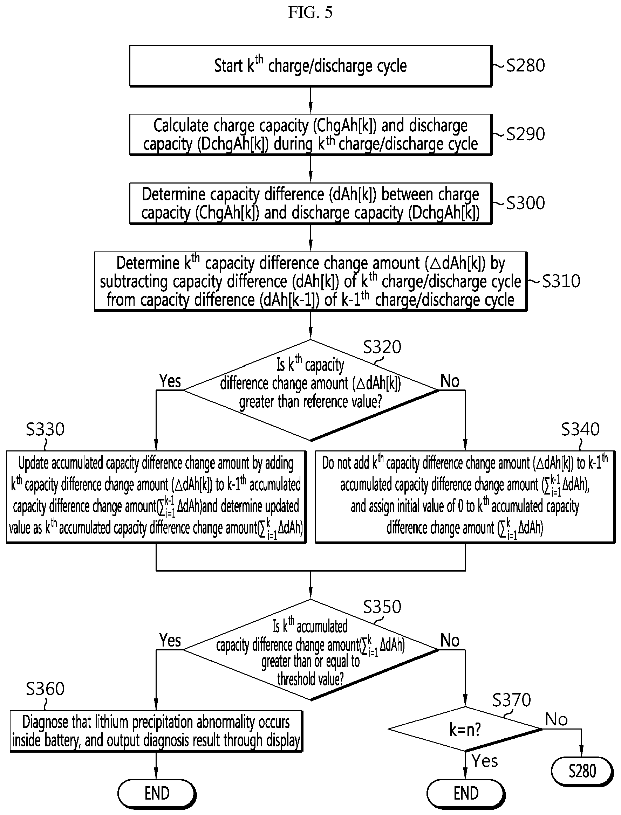

Hereinafter, a process performed by the control unit 18 in the 4th to nth charge/discharge cycles will be generalized and described with reference to FIG. 5.

In Step S280, the control unit 18 starts a kth (k is a natural number of 4 to n) charge/discharge cycle. Conditions of the kth charge/discharge cycle are substantially the same as those of the 1st charge/discharge cycle.

Subsequently, the control unit 18 determines a charge capacity (ChgAh[k]) and a discharge capacity (DchgAh[k]) during the kth charge/discharge cycle for the battery 11 in Step S290, and determines a capacity difference (dAh[k]) corresponding to the difference between the charge capacity (ChgAh[k]) and the discharge capacity (DchgAh[k]) in Step S300.

Subsequently, in Step S310, the control unit 18 determines a kth capacity difference change amount ($\triangle$dAh[k]) by subtracting the capacity difference (dAh[k]) of the kth charge/discharge cycle from a capacity difference (dAh[k-1]) of a k-1th charge/discharge cycle.

Subsequently, in Step S320, the control unit 18 judges whether the kth capacity difference change amount ($\triangle$dAh[k]) is greater than a reference value. Preferably, the reference value may be 0, but the present disclosure is not limited thereto.

If the judgment in Step S320 is YES, in Step S330, the control unit 18 updates the accumulated capacity difference change amount by adding the kth capacity difference change amount ($\triangle$dAh[k]) to the k-1th accumulated capacity difference change amount (

$$\sum_{i=1}^{k-1} \triangle dAh$$

) and determine the updated value as a kth accumulated capacity difference change amount (

$$\sum_{i=1}^{k} \triangle dAh$$

).

Meanwhile, if the judgment in Step S320 is NO, in Step S340, the control unit 18 does not add the kth capacity difference change amount ($\triangle$dAh[k]) to the k-1th accumulated capacity difference change amount (

$$\sum_{i=1}^{k-1} \triangle dAh$$

) and assigns the initial value of 0 to the kth accumulated capacity difference change amount

$$\Big( \sum_{i=1}^{k} \triangle dAh \Big).$$

After Step S330 and Step S340, Step S350 is performed.

In Step S350, the control unit 18 judges whether the kth accumulated capacity difference change amount (

$$\sum_{i=1}^{k} \triangle dAh$$

) is greater than or equal to a threshold value.

If the judgment in Step S350 is YES, in Step S360, the control unit 18 may diagnose that a lithium precipitation abnormality occurs inside the battery 11, and output the diagnosis result through the display 20. Preferably, the diagnosis result includes a warning message indicating that a lithium precipitation abnormality occurs. In Step S360, the control unit 18 may output the diagnosis result including a warning message through the display 20 and then terminate the diagnosis process.

If the judgment in Step S350 is NO, that is, if the $k^{th}$ accumulated capacity difference change amount (

$$\sum_{i=1}^{k} \triangle dAh$$

) is less than the threshold value (or, is 0), the control unit 18 judges whether the index k for the charge/discharge cycle is identical to k in Step S370. Here, n is the total number of charge/discharge cycles that can be performed to diagnose whether lithium precipitation occurs inside the battery 11.

If the judgment in Step S370 is YES, since the charge/discharge cycles for diagnosing lithium precipitation are completely performed, it is finally diagnosed that no lithium precipitation abnormality occurs inside the battery 11, and the process is terminated. The control unit 18 may output the final diagnosis result through the display 20. The final diagnosis result may include a message indicating that no lithium precipitation abnormality occurs.

Meanwhile, if the judgment in Step S370 is NO, the control unit 18 increases the index k of the charge/discharge cycle by 1 to further perform a charge/discharge cycle in order to diagnose a lithium precipitation abnormality, and then returns the process to S280. Thus, Steps S280 to S370 are periodically repeated until the index k of the charge/discharge cycle becomes n.

According to an embodiment of the present disclosure, when the capacity difference change amount calculated in the present charge/discharge cycle is less than or equal to the reference value, the accumulated capacity difference change amount calculated until the previous cycle is initialized to 0. In addition, if the capacity difference change amount calculated in the present charge/discharge cycle is greater than the reference value, the present capacity difference change amount is added to the previous accumulated capacity difference change amount. As a result, the accumulated capacity difference change amount increases. The previous accumulated capacity difference change amount has 0 or a positive value. If the accumulated capacity difference change amount has a positive value, capacity difference change amounts greater than the reference value calculated in consecutive charge/discharge cycles are accumulated. In addition, while the capacity difference change amounts being accumulated, if the capacity difference change amount decreases to the reference value or below in a specific charge/discharge cycle, the accumulated capacity difference change amount is initialized to 0. By applying this logic, the accumulated capacity difference change amount may be regarded as a kind of quantitative index that measures a lithium precipitation abnormality. That is, if the capacity difference change amount is greater than the reference value, it means that there is a possibility of lithium precipitation. In addition, if the accumulated capacity difference change amount increases to the threshold value or above while continuously satisfying the condition in which the capacity difference change amount exceeds the reference value in a plurality of time-sequentially consecutive charge/discharge cycles, this means that the possibility of lithium precipitation is high as much. The present disclosure has technical significance in that the possibility of lithium precipitation is quantified using a factor, called an accumulated capacity difference change amount.

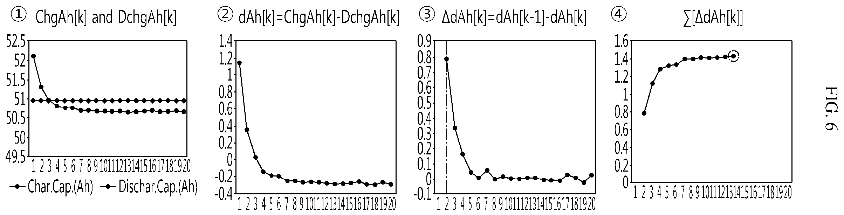

FIG. 6 is a graph showing the change in data measured in an experimental example to which a battery abnormality diagnosing method according to an embodiment of the present disclosure is applied.

In this experimental example, a pouch-type lithium polymer battery is used. The lithium polymer battery selected for the experiment is deteriorated and in a state where lithium starts to precipitate on the negative electrode. The present capacity of the lithium polymer battery, which reflects the degree of deterioration, is approximately 50 Ah. The charging condition of the charge cycle is CC (constant current)-CV (constant voltage) charging. When a CC charging target voltage is reached, the CC charging is terminated and converted into CV charging. When the CV charging current reaches a target current, the charging is terminated. The discharging condition of the discharge cycle is CC discharging, and the discharging is terminated when the discharging is performed as much as a given discharge capacity. The temperature condition of the charge cycle and the discharge cycle is 45°C. The reference value, which is the criterion for determining whether or not to integrate the capacity difference change amount, is 0, and the threshold value, which is the criterion for a diagnosing lithium precipitation abnormality, is set to 0.06 Ah.

A sense resistor is used as the current measuring unit 14. The analog voltage measured at both ends of the sense resistor is input to the I/O interface of the control unit 18. The control unit 18 includes a circuit that amplifies a voltage signal input through the I/O interface and converts the amplified analog signal into a digital signal. The current value measured through this circuit has a difference (offset) from the actual current value. In this experimental example, the discharge current measurement value has a larger error than the actual value. Accordingly, the discharge capacity may be greater than the charge capacity according to the index of the charge/discharge cycle.

Graph ① is a graph showing the measurement results of the charge capacity (ChgAh[k]) and the discharge capacity (DChgAh[k]) for each charge/discharge cycle. The charge capacity (ChgAh[k]) and the discharge capacity (DChgAh[k]) are calculated by integrating the current values measured through the sense resistor. Due to an error of the discharge current measurement value, the discharge capacity is greater than the charge capacity from the 4$^{th}$ discharge cycle.

Graph ② is a graph showing the capacity difference (dAh[k]) for each charge/discharge cycle. Seeing Graph ①, since the discharge capacity is greater than the charge capacity from the 4$^{th}$ charge/discharge cycle, the capacity difference (dAh[k]) becomes a negative value from the 4$^{th}$ cycle.

Graph ③ is a graph showing a capacity difference change amount ($\triangle$dAh[k]) for each charge/-discharge cycle. The indices of charge/discharge cycles in which the capacity difference change amount ($\triangle$dAh[k]) is a positive number are 2 to 13, 17 to 18, and 20. The indices of charge/discharge cycles in which the capacity difference change amount ($\triangle$dAh[k]) is a negative number are 14 to 16 and 19.

Graph ④ is a graph showing an accumulated capacity difference change amount ( $\sum_{i=1}^{k} \triangle dAh$ ) for each charge/-discharge cycle. The index of a charge/-discharge cycle in which the capacity difference change amount ($\triangle$dAh[k]) is a positive number is 2 to 13. Therefore, as the capacity difference change amounts ($\triangle$dAh[k]) of the 2$^{th}$ to 13$^{th}$ charge/discharge cycles are accumulated, the accumulated capacity difference change amount ( $\sum_{i=1}^{k} \triangle dAh$ ) increases. In addition, when the capacity difference change amount of the 13$^{th}$ charge/discharge cycle is accumulated, the accumulated capacity difference change amount ( $\sum_{i=1}^{k} \triangle dAh$ ) exceeds the threshold value of 0.06 Ah. Therefore, performing the 13$^{th}$ charge/discharge cycle, the control unit 18 diagnoses that a lithium precipitation abnormality occurs inside the battery, outputs the diagnosis result through the display 20, and terminates the diagnosis process. Since lithium is precipitated on the negative electrode of the lithium polymer battery used in this experiment, it may be found that the diagnostic accuracy of the present disclosure is high.

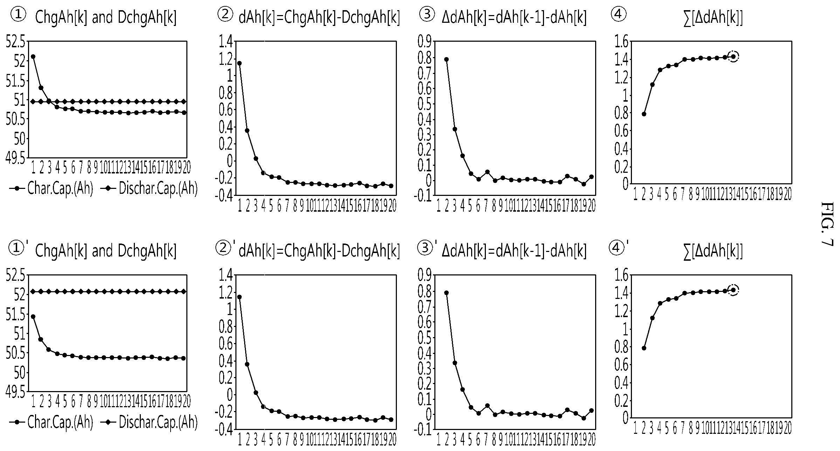

FIG. 7 is a graph showing the change in data measured in another experimental example to which the battery abnormality diagnosing method according to an embodiment of the present disclosure is applied.

In FIG. 7, Graph ① is the same as Graph ① of the experimental example described above. Graph ①' is a graph showing the measurement results of the charge capacity (ChgAh[k]) and the discharge capacity (DchgAh[k]) when a current measuring unit having a current measurement value error different from that of the experimental example described above is used. In this experimental example, the error of the discharge current measurement value is larger than that of the experimental example described above. Therefore, the graph of the discharge capacity (DchgAh[k]) is shifted upward compared to the experimental example described above.

Graphs ② and ②' are graphs showing a capacity difference (dAh[k]) for each charge/discharge cycle, Graphs ③ and ③' are graphs showing a capacity difference change amount ($\triangle$dAh[k]) for each charge/-discharge cycle, and Graphs ④ and ④' are graphs showing an accumulated capacity difference change amount ( $\sum_{i=1}^{k} \triangle dAh$ ) for each charge/discharge cycle.

Graphs ②③ and ④ are calculated using the data of Graph ①, and Graphs ②', ③' and ④' are calculated using the data of Graph ①'.

As shown in FIG. 7, Graphs ②, ③, and ④ and Graphs ②', ③', and ④' are substantially the same. Therefore, even if the discharge current value has a measurement error, the control unit 18 performs the 13$^{th}$ charge/discharge cycle regardless of the magnitude of the error, then diagnoses that a lithium precipitation abnormality occurs inside the battery, outputs the diagnosis result through the display 20, and terminates the diagnosis process. From these experimental results, it may be found that the present disclosure can reliably diagnose a lithium precipitation abnormality regardless of the error of the current measurement value.

Preferably, the battery abnormality diagnosing apparatus 10 according to an embodiment of the present disclosure may be included in a diagnosing system for diagnosing whether the battery 11 is abnormal. The diagnosing system may be operated by an electric vehicle maintenance shop, a battery manufacturer, or a battery maintenance company.

Preferably, the diagnosing system may be used for diagnosing abnormality of a battery installed in an electric vehicle or an energy storage system, or for diagnosing abnormality of a battery of a newly developed model produced by a battery manufacturer. In particular, in the latter case, before commercializing a battery of a newly developed model, the battery abnormality diagnosing apparatus 10 can be used to examine whether the battery contains a structural weakness that causes lithium precipitation.

Alternatively, the battery abnormality diagnosing apparatus 10 may be included in a control element of a system in which the battery 11 is installed.

In one example, the battery abnormality diagnosing apparatus 10 may be included in a control system of an electric vehicle. In this case, the battery abnormality diagnosing apparatus 10 may collect data on the charge capacity and discharge capacity of the battery in the process of charging and discharging the battery mounted in the electric vehicle, diagnose a lithium precipitation abnormality using the collected data, and output the diagnosis result to an integrated control display of the electric vehicle.

In the present disclosure, the electric vehicle refers to a vehicle driven by a motor, such as an electric vehicle, a hybrid electric vehicle, or a plug-in hybrid vehicle. The vehicle may be two-wheeled, three-wheeled or four-wheeled.

In another example, the battery abnormality diagnosing apparatus 10 may be included in a control system of an energy storage system. In this case, the battery abnormality diagnosing apparatus 10 may collect data on the charge capacity and discharge capacity of the battery in the process of charging and discharging the energy storage system, diagnose a lithium precipitation abnormality using the collected data, and output the diagnosis result through a display of an integrated management computer accessible by an operator.

Users of electric vehicles or operators of energy storage systems may take appropriate safety measures when the diagnosis result of lithium precipitation abnormality is output through the display. In one example, a user of an electric vehicle may visit a maintenance shop and receive an inspection. In another example, an operator of an energy storage system may replace a corresponding battery with a new battery.

In the present disclosure, the control unit 18 may be a control circuit. The control unit 18 may optionally include a processor, an application-specific integrated circuit (ASIC), other chipsets, logic circuits, registers, communication modems, data processing devices, etc. known in the art to execute the various control logics described above. Also, when the control logic is implemented as software, the control unit 18 may be implemented as a set of program modules. At this time, the program module may be stored in a memory and executed by the processor. The memory may be provided inside or outside the processor, and may be connected to the processor by various well-known computer components. Also, the memory may be included in the storage unit 17 of the present disclosure. Also, the memory generically refers to a device that stores information regardless of the type of device, and does not refer to a specific memory device.

One or more of the various control logics of the control unit 18 are combined, and the combined control logics may be written in a computer-readable code system and recorded on a computer-readable recording medium. The type of the recording medium is not particularly limited as long as it can be accessed by a processor included in a computer. As an example, the recording medium includes at least one selected from the group including a ROM, a RAM, a register, a CD-ROM, a magnetic tape, a hard disk, a floppy disk, and an optical data recording device. In addition, the code system may be distributed and stored and executed in computers connected through a network. In addition, functional programs, codes and code segments for implementing the combined control logics may be easily inferred by programmers in the art to which the present disclosure belongs.

In describing various embodiments of the present disclosure, elements named '... unit' should be understood as functionally distinct elements rather than physically distinct elements. Thus, each component may be selectively integrated with other components or each component may be divided into sub-components for efficient execution of control logic(s). However, it is obvious to those skilled in the art that even if the components are integrated or divided, if the same function can be recognized, the integrated or divided components should also be interpreted as falling within the scope of the present disclosure.

The present disclosure has been described in detail. However, it should be understood that the detailed description and specific examples, while indicating preferred embodiments of the disclosure, are given by way of illustration only, since various changes and modifications within the scope of the disclosure will become apparent to those skilled in the art from this detailed description. The scope of the disclosure is defined by the appended claims.

## Claims

1. A battery abnormality diagnosing apparatus, comprising:

   a current measuring unit configured to measure a charging current or a discharging current of a battery; and
   a control unit operably coupled with the current measuring unit and configured to diagnose a lithium precipitation abnormality while performing a plurality of charge/discharge cycles for the battery,
   **characterised in that** the control unit is configured to receive a current measurement value from the current measuring unit in a $k^{th}$ (k is a natural number greater than or equal to 2) charge/discharge cycle to calculate a charge capacity and a discharge capacity, determine a capacity difference corresponding to a difference between the charge capacity and the discharge capacity, determine a $k^{th}$ capacity difference change amount by subtracting the capacity difference of the $k^{th}$ charge/discharge cycle from a capacity difference of a $k\text{-}1^{th}$ charge/discharge cycle, update an accumulated capacity difference change amount by adding the $k^{th}$ capacity difference change amount to the accumulated capacity difference change amount, and diagnose that a lithium precipitation abnormality occurs when the updated accumulated capacity difference change amount is greater than or equal to a threshold value.

2. The battery abnormality diagnosing apparatus according to claim 1,
wherein the control unit is configured to update the accumulated capacity difference change amount by adding the $k^{th}$ capacity difference change amount to the accumulated capacity difference change amount when the $k^{th}$ capacity difference change amount is greater than a reference value.

3. The battery abnormality diagnosing apparatus according to claim 1,
wherein the control unit is configured to update the accumulated capacity difference change amount by adding the $k^{th}$ capacity difference change amount to the accumulated capacity difference change amount when both the $k\text{-}1^{th}$ capacity difference change amount and the $k^{th}$ capacity difference change amount are greater than a reference value.

4. The battery abnormality diagnosing apparatus according to claim 1,
wherein the control unit is configured to assign an initial value of 0 to the accumulated capacity difference change amount when the $k^{th}$ capacity difference change amount is less than or equal to a reference value.

5. The battery abnormality diagnosing apparatus according to any one of claims 2 to 4,
wherein the reference value is 0.

6. The battery abnormality diagnosing apparatus according to claim 1,
wherein when performing each charge/discharge cycle, the control unit is configured to perform the charge cycles in the same charging voltage section and perform the discharge cycles in the same discharging voltage section.

7. The battery abnormality diagnosing apparatus according to claim 1,
wherein when performing each charge/discharge cycle, the control unit is configured to perform the charge cycles in the same charging voltage section and perform the discharge cycles in the same discharge capacity condition.

8. The battery abnormality diagnosing apparatus according to claim 1, further comprising:

a display coupled to the control unit,
wherein the control unit is configured to diagnose that a lithium precipitation abnormality occurs when the accumulated capacity difference change amount is greater than or equal to the threshold value and output a diagnosis result through the display.

9. A system, comprising the battery abnormality diagnosing apparatus according to any one of claims 1 to 8.

10. An electric vehicle, comprising the battery abnormality diagnosing apparatus according to any one of claims 1 to 8.

11. A battery abnormality diagnosing method for diagnosing whether a battery is abnormal by performing a plurality of charge/discharge cycles for the battery, comprising:

(a) receiving a current measurement value from a current measuring unit in a $k^{th}$ (k is a natural number greater than or equal to 2) charge/discharge cycle to calculate a charge capacity and a discharge capacity and **characterised by**
(b) determining a capacity difference corresponding to a difference between the charge capacity and the discharge capacity;
(c) determining a $k^{th}$ capacity difference change amount by subtracting the capacity difference of the $k^{th}$ charge/discharge cycle from a capacity difference of a $k\text{-}1^{th}$ charge/discharge cycle;
(d) updating an accumulated capacity difference change amount by adding the $k^{th}$ capacity difference change amount to the accumulated capacity difference change amount; and
(e) diagnosing that a lithium precipitation abnormality occurs when the updated accumulated capacity difference change amount is greater than or equal to a threshold value.

12. The battery abnormality diagnosing method according to claim 11,
wherein in the step (d), the accumulated capacity difference change amount is updated by adding the $k^{th}$ capacity difference change amount to the accumulated capacity difference change amount when the $k^{th}$ capacity difference change amount is greater than a reference value.

13. The battery abnormality diagnosing method according to claim 11,
wherein in the step (d), the accumulated capacity difference change amount is updated by adding the $k^{th}$ capacity difference change amount to the accumulated capacity difference change amount when both the $k\text{-}1^{th}$ capacity difference change amount and the $k^{th}$ capacity difference change amount are greater than a reference value.

14. The battery abnormality diagnosing method according to claim 11, further comprising:
assigning an initial value of 0 to the accumulated capacity difference change amount when the $k^{th}$ capacity difference change amount is less than or equal to a reference value.

15. The battery abnormality diagnosing method according to any one of claims 12-14,
wherein the reference value is 0.


**Patentansprüche**

1. Batterieanomalie-Diagnosevorrichtung, umfassend:

eine Strommesseinheit, welche dazu eingerichtet ist, einen Ladestrom oder einen Entladestrom einer Batterie zu messen; und
eine Steuerungseinheit, welche operativ mit der Strommesseinheit gekoppelt und dazu eingerichtet ist, eine Lithiumpräzipitationsanomalie zu diagnostizieren,
während eine Mehrzahl von Lade/Entladezyklen für die Batterie durchgeführt werden,
**dadurch gekennzeichnet, dass** die Steuerungseinheit dazu eingerichtet ist, einen Strommesswert von der Strommesseinheit in einem k-ten (k ist eine natürliche Zahl größer als oder gleich wie 2) Lade/Entladezyklus zu erhalten, um eine Ladekapazität und eine Entladekapazität zu berechnen, eine Kapazitätsdifferenz entsprechend einem Unterschied zwischen der Ladekapazität und der Entladekapazität zu bestimmen, einen k-ten Kapazitätsdifferenz-Änderungsbetrag durch Subtrahieren der Kapazitätsdifferenz des k-ten Lade/Entladezyklus von einer Kapazitätsdifferenz eines k-1-ten Lade/Entladezyklus zu bestimmen, einen akkumulierten Kapazitätsdifferenz-Änderungsbetrag durch Addieren des k-ten Kapazitätsdifferenz-Änderungsbetrags zu dem akkumulierten Kapazitätsdifferenz-Änderungsbetrag zu aktualisieren, und zu diagnostizieren, dass eine Lithiumpräzipitationsanomalie auftritt, wenn der aktualisierte akkumulierte Kapazitätsdifferenz-Änderungsbetrag größer als oder gleich wie ein Schwellenwert ist.

2. Batterieanomalie-Diagnosevorrichtung nach Anspruch 1, wobei die Steuerungseinheit dazu eingerichtet ist, den akkumulierten Kapazitätsdifferenz-Änderungsbetrag durch Addieren des k-ten Kapazitätsdifferenz-Änderungsbetrags zu dem akkumulierten Kapazitätsdifferenz-Änderungsbetrag zu aktualisieren, wenn der k-te Kapazitätsdifferenz-Änderungsbetrag größer als ein Referenzwert ist.

3. Batterieanomalie-Diagnosevorrichtung nach Anspruch 1, wobei die Steuerungseinheit dazu eingerichtet ist, den akkumulierten Kapazitätsdifferenz-Änderungsbetrag durch Addieren des k-ten Kapazitätsdifferenz-Änderungsbetrags zu dem akkumulierten Kapazitätsdifferenz-Änderungsbetrag zu aktualisieren, wenn sowohl der k-1-te Kapazitätsdifferenz-Änderungsbetrag als auch der k-te Kapazitätsdifferenz-Änderungsbetrag größer als ein Referenzwert sind.

4. Batterieanomalie-Diagnosevorrichtung nach Anspruch 1, wobei die Steuerungseinheit dazu eingerichtet ist, dem akkumulierten Kapazitätsdifferenz-Änderungsbetrag einen initialen Wert von 0 zuzuordnen, wenn der k-te Kapazitätsdifferenz-Änderungsbetrag kleiner als oder gleich wie ein Referenzwert ist.

5. Batterieanomalie-Diagnosevorrichtung nach einem der Ansprüche 2 bis 4, wobei der Referenzwert 0 ist.

6. Batterieanomalie-Diagnosevorrichtung nach Anspruch 1, wobei, beim Durchführen jedes Lade/Entladezyklus, die Steuerungseinheit dazu eingerichtet ist, die Ladezyklen in dem gleichen Ladespannungsbereich durchzuführen und die Entladezyklen in dem gleichen Entladespannungsbereich durchzuführen.

7. Batterieanomalie-Diagnosevorrichtung nach Anspruch 1, wobei, beim Durchführen jedes Lade/Entladezyklus, die Steuerungseinheit dazu eingerichtet ist, die Ladezyklen in dem gleichen Ladespannungsbereich durchzuführen und die Entladezyklen unter der gleichen Entladekapazitätsbedingung durchzuführen.

8. Batterieanomalie-Diagnosevorrichtung nach Anspruch 1, ferner umfassend:

eine mit der Steuerungseinheit gekoppelte Anzeige,
wobei die Steuerungseinheit dazu eingerichtet ist, zu diagnostizieren, dass eine Lithiumpräzipitationsanomalie auftritt, wenn der akkumulierte Kapazitätsdifferenz-Änderungsbetrag größer als oder gleich wie der Schwellenwert ist, und ein Diagnoseergebnis durch die Anzeige auszugeben.

9. System, umfassend die Batterieanomalie-Diagnosevorrichtung nach einem der Ansprüche 1 bis 8.

10. Elektrisches Fahrzeug, umfassend die Batterieanomalie-Diagnosevorrichtung nach einem der Ansprüche 1 bis 8.

11. Batterieanomalie-Diagnoseverfahren zum Diagnostizieren, ob eine Batterie anormal ist, durch Durchführen einer Mehrzahl von Lade/Entladezyklen für die Batterie, umfassend:

(a) Erhalten eines Strommesswerts von einer Strommesseinheit in einem k-ten (k ist eine natürliche Zahl größer als oder gleich wie 2) Lade/Entladezyklus, um eine Ladekapazität und eine Entladekapazität zu berechnen, und **gekennzeichnet durch**
(b) Bestimmen einer Kapazitätsdifferenz, welche einer Differenz zwischen der Ladekapazität und der Entladekapazität entspricht;
(c) Bestimmen eines k-ten Kapazitätsdifferenz-Änderungsbetrags durch Subtrahieren der Kapazitätsdifferenz des k-ten Lade/Entladezyklus von einer Kapazitätsdifferenz eines k-1-ten Lade/Entladezyklus;
(d) Aktualisieren eines akkumulierten Kapazitätsdifferenz-Änderungsbetrags durch Addieren des k-ten Kapazitätsdifferenz-Änderungsbetrags zu dem akkumulierten Kapazitätsdifferenz-Änderungsbetrag; und
(e) Diagnostizieren, dass eine Lithiumpräzipitationsanomalie auftritt, wenn der aktualisierte akkumulierte Kapazitätsdifferenz-Änderungsbetrag größer als oder gleich wie ein Schwellenwert ist.

12. Batterieanomalie-Diagnoseverfahren nach Anspruch 11, wobei in dem Schritt (d) der akkumulierte Kapazitätsdifferenz-Änderungsbetrag durch Addieren des k-ten Kapazitätsdifferenz-Änderungsbetrags zu dem akkumulierten Kapazitätsdifferenz-Änderungsbetrag aktualisiert wird, wenn der k-te Kapazitätsdifferenz-Änderungsbetrag größer als ein Referenzwert ist.

13. Batterieanomalie-Diagnoseverfahren nach Anspruch 11, wobei in dem Schritt (d) der akkumulierte Kapazitätsdifferenz-Änderungsbetrag durch Addieren des k-ten Kapazitätsdifferenz-Änderungsbetrags zu dem akkumulierten Kapazitätsdifferenz-Änderungsbetrag aktualisiert wird, wenn sowohl der k-1-te Kapazitätsdifferenz-Änderungsbetrag als auch der k-te Kapazitätsdifferenz-Änderungsbetrag größer als ein Referenzwert sind.

14. Batterieanomalie-Diagnoseverfahren nach Anspruch 11, ferner umfassend:
Zuordnen eines initialen Wertes von 0 zu dem akkumulierten Kapazitätsdifferenz-Änderungsbetrag, wenn der k-te Kapazitätsdifferenz-Änderungsbetrag kleiner als oder gleich wie ein Referenzwert ist.

15. Batterieanomalie-Diagnoseverfahren nach einem der Ansprüche 12-14, wobei der Referenzwert 0 ist.

**Revendications**

1. Appareil de diagnostic d'anomalie de batterie, comprenant :

une unité de mesure de courant configurée pour mesurer un courant de charge ou un courant de décharge d'une batterie ; et
une unité de commande couplée de manière opérationnelle à l'unité de mesure de courant et configurée pour diagnostiquer une anomalie de précipitation de lithium tout en réalisant une pluralité de cycles de charge/décharge pour la batterie, **caractérisé en ce que**
l'unité de commande est configurée pour recevoir une valeur de mesure de courant de l'unité de mesure de courant dans un $k^{ème}$ cycle de charge/décharge (k est un entier naturel supérieur ou égal à 2) pour calculer une capacité de charge et une capacité de décharge, déterminer une différence de capacité correspondant à une différence entre la capacité de charge et la capacité de décharge, déterminer une $k^{ème}$ quantité de changement de différence de capacité en soustrayant la différence de capacité du $k^{ème}$ cycle de charge/décharge d'une différence de capacité d'un $k-1^{ème}$ cycle de charge/décharge, mettre à jour une quantité de changement de différence de capacité accumulée en ajoutant la $k^{ème}$ quantité de changement de différence de capacité à la quantité de changement de différence de capacité accumulée, et diagnostiquer qu'une anomalie de précipitation de lithium se produit lorsque la quantité de changement de différence de capacité accumulée mise à jour est supérieure ou égale à une valeur seuil.

2. Appareil de diagnostic d'anomalie de batterie selon la revendication 1,
dans lequel l'unité de commande est configurée pour mettre à jour la quantité de changement de différence de capacité accumulée en ajoutant la $k^{ème}$ quantité de changement de différence de capacité à la quantité de changement de différence de capacité accumulée lorsque la $k^{ème}$ quantité de changement de différence de capacité est supérieure à une valeur de référence.

3. Appareil de diagnostic d'anomalie de batterie selon la revendication 1,
dans lequel l'unité de commande est configurée pour mettre à jour la quantité de changement de différence de capacité accumulée en ajoutant la $k^{ème}$ quantité de changement de différence de capacité à la quantité de changement de différence de capacité accumulée lorsque la $k-1^{ème}$ quantité de changement de différence de capacité et la $k^{ème}$ quantité de changement de différence de capacité sont toutes deux supérieures à une valeur de référence.

4. Appareil de diagnostic d'anomalie de batterie selon la revendication 1, dans lequel l'unité de commande est configurée pour attribuer une valeur initiale de 0 à la quantité de changement de différence de capacité accumulée lorsque la k$^{ème}$ quantité de changement de différence de capacité est inférieure ou égale à une valeur de référence.

5. Appareil de diagnostic d'anomalie de batterie selon l'une quelconque des revendications 2 à 4, dans lequel la valeur de référence est 0.

6. Appareil de diagnostic d'anomalie de batterie selon la revendication 1, dans lequel lors de la réalisation de chaque cycle de charge/décharge, l'unité de commande est configurée pour réaliser les cycles de charge dans la même section de tension de charge et réaliser les cycles de décharge dans la même section de tension de décharge.

7. Appareil de diagnostic d'anomalie de batterie selon la revendication 1, dans lequel lors de la réalisation de chaque cycle de charge/décharge, l'unité de commande est configurée pour réaliser les cycles de charge dans la même section de tension de charge et réaliser les cycles de décharge dans la même condition de capacité de décharge.

8. Appareil de diagnostic d'anomalie de batterie selon la revendication 1, comprenant en outre :

   une unité d'affichage couplée à l'unité de commande, dans lequel l'unité de commande est configurée pour diagnostiquer qu'une anomalie de précipitation de lithium se produit lorsque la quantité de changement de différence de capacité accumulée est supérieure ou égale à la valeur seuil et délivre un résultat de diagnostic par le biais de l'unité d'affichage.

9. Système, comprenant l'appareil de diagnostic d'anomalie de batterie selon l'une quelconque des revendications 1 à 8.

10. Véhicule électrique, comprenant l'appareil de diagnostic d'anomalie de batterie selon l'une quelconque des revendications 1 à 8.

11. Procédé de diagnostic d'anomalie de batterie permettant de diagnostiquer si oui ou non une batterie est anormale en réalisant une pluralité de cycles de charge/décharge pour la batterie, comprenant :

   (a) la réception d'une valeur de mesure de courant à partir d'une unité de mesure de courant dans un k$^{ème}$ (k est un entier naturel supérieur ou égal à 2) cycle de charge/décharge pour calculer une capacité de charge et une capacité de décharge et **caractérisé par**
   (b) la détermination d'une différence de capacité correspondant à une différence entre la capacité de charge et la capacité de décharge ;
   (c) la détermination d'une k$^{ème}$ quantité de changement de différence de capacité en soustrayant la différence de capacité du k$^{ème}$ cycle de charge/décharge d'une différence de capacité d'un k-1$^{ème}$ cycle de charge/décharge ;
   (d) la mise à jour d'une quantité de changement de différence de capacité accumulée en ajoutant la k$^{ème}$ quantité de changement de différence de capacité à la quantité de changement de différence de capacité accumulée ; et
   (e) le diagnostic qu'une anomalie de précipitation de lithium se produit lorsque la quantité de changement de différence de capacité accumulée mise à jour est supérieure ou égale à une valeur seuil.

12. Procédé de diagnostic d'anomalie de batterie selon la revendication 11, dans lequel, dans l'étape (d), la quantité de changement de différence de capacité accumulée est mise à jour en ajoutant la k$^{ème}$ quantité de changement de différence de capacité à la quantité de changement de différence de capacité accumulée lorsque la k$^{ème}$ quantité de changement de différence de capacité est supérieure à une valeur de référence.

13. Procédé de diagnostic d'anomalie de batterie selon la revendication 11, dans lequel, dans l'étape (d), la quantité de changement de différence de capacité accumulée est mise à jour en ajoutant la k$^{ème}$ quantité de changement de différence de capacité à la quantité de changement de différence de capacité accumulée lorsque la k-1$^{ème}$ quantité de changement de différence de capacité et la k$^{ème}$ quantité de changement de différence de capacité sont toutes deux supérieures à une valeur de référence.

14. Procédé de diagnostic d'anomalie de batterie selon la revendication 11, comprenant en outre : l'attribution d'une valeur initiale de 0 à la quantité de changement de différence de capacité accumulée lorsque la k$^{ème}$ quantité de changement de différence de capacité est inférieure ou égale à une valeur de référence.

15. Procédé de diagnostic d'anomalie de batterie selon l'une quelconque des revendications 12 à 14, dans lequel la valeur de référence est 0.

FIG. 1

10

FIG. 2

```
                    ┌──────────────┐
                    │    START     │
                    └──────┬───────┘
                           │
   ┌───────────────────────────────────────────────────┐
   │   Initialize charge/discharge cycle index k to 1   │─S10
   └───────────────────────┬───────────────────────────┘
                           │
   ┌───────────────────────────────────────────────────┐
   │ Initialize 1ˢᵗ capacity difference change amount   │
   │ △dAh[1] and 1ˢᵗ accumulated capacity difference    │─S20
   │ change amount (∑¹ᵢ₌₁ △dAh) to 0                    │
   └───────────────────────┬───────────────────────────┘
                           │
   ┌───────────────────────────────────────────────────┐
   │        Start 1ˢᵗ charge/discharge cycle            │─S30
   └───────────────────────┬───────────────────────────┘
                           │
   ┌───────────────────────────────────────────────────┐
   │  Calculate charge capacity (ChgAh[1]) and          │─S40
   │  discharge capacity (DchgAh[1]) of 1ˢᵗ             │
   │  charge/discharge cycle                            │
   └───────────────────────┬───────────────────────────┘
                           │
   ┌───────────────────────────────────────────────────┐
   │  Determine capacity difference (dAh[1]) between    │─S50
   │  charge capacity (ChgAh[1]) and discharge          │
   │  capacity (DchgAh[1])                              │
   └───────────────────────┬───────────────────────────┘
```

Initialize 1ˢᵗ capacity difference change amount $\triangle dAh[1]$ and 1ˢᵗ accumulated capacity difference change amount $(\sum_{i=1}^{1} \triangle dAh)$ to 0  — S20

Start 1ˢᵗ charge/discharge cycle — S30

Calculate charge capacity (ChgAh[1]) and discharge capacity (DchgAh[1]) of 1ˢᵗ charge/discharge cycle — S40

Determine capacity difference (dAh[1]) between charge capacity (ChgAh[1]) and discharge capacity (DchgAh[1]) — S50

S60 — k=n?  —Yes→ END

No

start 2ᵗʰ charge/discharge cycle — S70

Calculate charge capacity (ChgAh[2]) and discharge capacity (DchgAh[2]) during 2ᵗʰ charge/discharge cycle — S80

Determine capacity difference (dAh[2]) between charge capacity (ChgAh[2]) and discharge capacity (DchgAh[2]) — S90

Determine 2ᵗʰ capacity difference change amount ($\triangle dAh[2]$) by subtracting capacity difference (dAh[2]) of 2ᵗʰ charge/discharge cycle from capacity difference (dAh[1]) of 1ˢᵗ charge/discharge cycle — S100

A

FIG. 3

A

S110
Is 2th capacity difference change amount ($\triangle$dAh[2]) greater than reference value?

Yes → S120
No → S130

S120
Update accumulated capacity difference change amount by adding 2th capacity difference change amount($\triangle$dAh[2])to 1st accumulated capacity difference change amount($\sum_{i=1}^{1}\triangle$dAh)and determine updated value as 2th accumulated capacity difference change amount($\sum_{i=1}^{2}\triangle$dAh)

S130
2th capacity difference change amount ($\triangle$dAh[2]) is not added to 1st accumulated capacity difference change amount ($\sum_{i=1}^{1}\triangle$dAh), and initial value 0 is assigned to 2th accumulated capacity difference change amount ($\sum_{i=1}^{2}\triangle$dAh)

S140
Is 2th accumulated capacity difference change amount($\sum_{i=1}^{2}\triangle$dAh) greater than or equal to a threshold value?

Yes → S150
No → S160

S150
Diagnose that lithium precipitation abnormality occurs inside battery, and output diagnosis result through display

END

S160
k=n?
No → B
Yes → END

FIG. 4

B

Start 3$^{th}$ charge/discharge cycle —S180

Calculate charge capacity (ChgAh[3]) and discharge capacity (DchgAh[3]) during 3$^{th}$ charge/discharge cycle —S190

Determine capacity difference (dAh[3]) between charge capacity (ChgAh[3]) and discharge capacity (DchgAh[3]) —S200

Determine 3$^{th}$ capacity difference change amount ($\triangle$dAh[3]) by subtracting capacity difference (dAh[3]) of 3$^{th}$ charge/discharge cycle from capacity difference (dAh[2]) of 2$^{th}$ charge/discharge cycle —S210

S220
Is 3$^{th}$ capacity difference change amount ($\triangle$dAh[3]) greater than reference value?

Yes

No

S230
Update accumulated capacity difference change amount by adding 3$^{th}$ capacity difference change amount ($\triangle$dAh[3]) to 2$^{th}$ accumulated capacity difference change amount($\sum_{i=1}^{2}\triangle$dAh)and determine updated value as 3$^{th}$ accumulated capacity difference change amount($\sum_{i=1}^{3}\triangle$dAh)

S240
Do not add 3$^{th}$ capacity difference change amount ($\triangle$dAh[3]) to 2$^{th}$ accumulated capacity difference change amount ($\sum_{i=1}^{2}\triangle$dAh), and assign initial value 0 to 3$^{th}$ accumulated capacity difference change amount ($\sum_{i=1}^{3}\triangle$dAh)

S250
Is 3$^{th}$ accumulated capacity difference change amount($\sum_{i=1}^{3}\triangle$dAh) greater than threshold value?

Yes

No

S260
Diagnose that lithium precipitation abnormality occurs inside battery, and output diagnosis result through display

S270
k=n?

No

Yes

S280

END

END

FIG. 5

Start $k^{th}$ charge/discharge cycle — S280

Calculate charge capacity (ChgAh[k]) and discharge capacity (DchgAh[k]) during $k^{th}$ charge/discharge cycle — S290

Determine capacity difference (dAh[k]) between charge capacity (ChgAh[k]) and discharge capacity (DchgAh[k]) — S300

Determine $k^{th}$ capacity difference change amount ($\triangle$dAh[k]) by subtracting capacity difference (dAh[k]) of $k^{th}$ charge/discharge cycle from capacity difference (dAh[k-1]) of k-1$^{th}$ charge/discharge cycle — S310

S320
Is $k^{th}$ capacity difference change amount ($\triangle$dAh[k]) greater than reference value?

Yes

No

S330
Update accumulated capacity difference change amount by adding $k^{th}$ capacity difference change amount ($\triangle$dAh[k]) to k-1$^{th}$ accumulated capacity difference change amount($\sum_{i=1}^{k-1}\triangle$dAh)and determine updated value as $k^{th}$ accumulated capacity difference change amount($\sum_{i=1}^{k}\triangle$dAh)

S340
Do not add $k^{th}$ capacity difference change amount ($\triangle$dAh[k]) to k-1$^{th}$ accumulated capacity difference change amount ($\sum_{i=1}^{k-1}\triangle$dAh), and assign initial value of 0 to $k^{th}$ accumulated capacity difference change amount ($\sum_{i=1}^{k}\triangle$dAh)

S350
Is $k^{th}$ accumulated capacity difference change amount($\sum_{i=1}^{k}\triangle$dAh) greater than or equal to threshold value?

Yes

No

S360
Diagnose that lithium precipitation abnormality occurs inside battery, and output diagnosis result through display

END

S370
k=n?

No

Yes

S280

END

FIG. 6

FIG. 7

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- KR 1020210166209
- KR 1020220157731

- US 2019140325 A1